# EUROPEAN PATENT APPLICATION

(11) **EP 1 798 751 A1**
(43) Date of publication of application: **20.06.2007**
(21) Application number: 05027205.3
(22) Date of filing: 13.12.2005
(51) Int. Cl.: H01J 37/18, H01J 37/301, H01J 5/02

(54) **Protecting aperture for charged particle emitter**

(71) Applicant: ICT Integrated Circuit Testing Gesellschaft für Halbleiterprüftechnik mbH, 85551 Heimstetten (DE)
(72) Inventor: Adamec, Pavel, 85540 Haar (DE)
(74) Representative: Zimmermann, Gerd Heinrich

(57) **Abstract**

A charged particle beam apparatus and a method are provided. The apparatus comprises a charged particle emitter (1) located within a gun chamber (11), the gun chamber being adapted to encompass a first pressure; at least one further vacuum chamber adapted to encompass a second pressure between one order and four orders of magnitude higher than the first pressure; a first aperture unit (102; 202, 402; 602; 702; 802); comprising at least a first aperture opening and a molecule blocking area; a second aperture unit (104; 204, 214) comprising a second aperture opening. Thereby, the first aperture unit and/or the second aperture unit is a differential pressure aperture separating two independently evacuateable vacuum chambers and being adapted for maintaining a pressure difference of at least two orders of magnitude and the emitter, the molecule blocking area (706; 806) and the second aperture opening are positioned to be on a straight line.

## Description

### FIELD OF THE INVENTION

The present invention generally relates to a charged particle apparatus and more particularly to a charged particle apparatus and a method with protection arrangements for an emitter located in vacuum. More specifically, the present invention relates to a charged particle beam apparatus and a method of protecting an emitter tip with an aperture.

### BACKGROUND OF THE INVENTION

Charged particle beam apparatuses are used in a plurality of industrial fields, including, but not limited to, high resolution imaging and processing of samples, inspection of semiconductor devices during manufacturing, exposure systems for lithography, detecting devices and testing systems. There is a high demand for structuring, testing and inspecting specimens within the micrometer and nanometer scale. Micrometer and nanometer scale process control, inspection, or structuring, is often done with charged particle beams, e.g. electron beams. Charged particle beams offer superior spatial resolution compared to, e.g. photon beams due to their short wavelengths.

Besides resolution, throughput is an issue of such devices. Since large substrate areas have to be patterned or inspected, it is desirable that the throughput is, for example larger than 10 cm²/min. In charged particle beam devices, the throughput depends on the charged particle beam current. Thus, there is a need for increasing the beam current.

In view of the desire for increased charged particle beam currents, high current charged particle beam emitters, such as field emission emitters have an enormous potential due to their high brightness. Yet, these and other emitters have an increased sensitivity for particles being adsorbed by the emitter. Residual gas molecules being adsorbed on the emitting surface of the emitter may cause poor stability of the emitter.

Generally there are three sources of gas molecules that are adsorbed on a surface of the emitter. There are molecules from residual gas within the gun chamber. There are molecules generated by stimulated desorption on impingement of the primary charged particle beam. Further, there are molecules having their origin in lower vacuum stages. This may for example be the specimen chamber.

For charged particle beam apparatuses, particularly for charged particle beam apparatuses with cold field emitters (CFE) or photoemitters, there are different chambers. Each chamber usually has its own vacuum level. In order to accomplish the different vacuum levels, the chambers may be separated with differential pressure apertures. The gun chamber, that is the chamber in which the emitter is located, needs to be cleaned in special cleaning steps to achieve the required vacuum conditions in the gun chamber. Thereby, the most critical parts are those which are illuminated by the charged particle beam, e.g. the extractor electrode. Thus, the gun chamber may be cleaned with electron bombardment. In this case vacuum levels in the gun chamber of 10⁻¹² torr (1.333*10⁻¹² mbar) or better can be realized. This results in a very small amount of molecules from the gun chamber that may be adsorbed by the emitter.

Generally, the flow of gas from higher pressure chambers, e.g. the specimen chamber (10⁻⁵ torr / 1.333*10⁻⁵ mbar), through differential pressure apertures may not be sufficient to change the pressure in higher vacuum chambers significantly. However, within prior art devices, the differential pressure aperture for separating the gun chamber from the other chamber or other chambers is located directly below the emitter. Thus, the probability of molecules originating from the specimen chamber being adsorbed on the surface of the emitter is about in the same range as for the molecules originating from the gun chamber itself. In special cases like ESEM there may even be approximately 1000 times more molecules originating from the specimen chamber being adsorbed on the surface of the emitter than molecules from the gun chamber being adsorbed on the surface of the emitter.

In view of the specimen being replaced on a regular basis and in view of the outgasing of the new specimen, it is very difficult to improve the vacuum in the specimen chamber without increasing time a specimen is located in the specimen chamber. Thereby, however, the throughput of the system may deteriorate.

Consequently, there is a desire for protecting the emitter also from molecules not originating from the gun chamber.

### SUMMARY OF THE INVENTION

In view of the above, a charged particle beam apparatus is provided. The charged particle beam apparatus includes: a charged particle emitter located within a gun chamber, the gun chamber being adapted to encompass a first pressure; at least one further vacuum chamber adapted to encompass a second pressure between one order and four orders of magnitude higher than the first pressure; a first aperture unit including a molecule blocking area and at least one first aperture opening; a second aperture unit including a second aperture opening, wherein the first aperture unit and/or the second aperture unit is a differential pressure aperture separating two independently evacuateable vacuum chambers and being adapted for maintaining a pressure difference of at least two orders of magnitude, and wherein the emitter, the molecule blocking area and the second aperture opening are positioned to be on a straight line.

Yet, typically the at least one first aperture opening, the second aperture opening and the emitter are not located on a straight line or prevent direct sight from the position of the emitter to the specimen chamber.

Even further, the molecule blocking area is typically a central molecule blocking area. That is, it is located substantially in the center of the aperture unit or substantially on the optical axis of the charged particle beam apparatus.

Thus, an arrangement of differential pressure apertures is proposed that eliminates direct sight of the specimen chamber (wafer chamber) to the charged particle beam emitter. Thereby, the probability of molecules having their origin outside the gun chamber, e.g. in the specimen chamber, being adsorbed on the emitter surface is reduced. As a result, the sensitivity of the emitter to the conditions outside the gun chamber, that is e.g. in the specimen chamber, is reduced.

Further advantages, features, aspects and details are evident from the dependent claims, the description and the drawings.

According to an embodiment a charged particle beam apparatus is provided, wherein the second aperture unit is a differential pressure aperture separating the gun chamber from the further vacuum chamber and being adapted for maintaining a pressure difference of at least two orders of magnitude.

According to another embodiment a charged particle beam apparatus is provided, wherein a specimen chamber being adapted to encompass a third pressure between one order and four orders of magnitude higher than the second pressure is included and wherein the second aperture unit is a differential pressure aperture separating the specimen chamber from the further vacuum chamber and being adapted for holding a pressure difference of at least two orders of magnitude.

According to another embodiment a charged particle beam apparatus is provided, the apparatus including: a charged particle emitter located within a gun chamber, the gun chamber having a first pressure; the charged particle beam emitter including an emitter tip adapted for emission of a charged particle beam; a first differential pressure aperture including at least one first aperture opening, a second differential pressure aperture including a second aperture opening, the second differential pressure aperture separating the gun chamber from a further chamber or a further chamber from a specimen chamber, the gun chamber being adapted for a pressure at least a factor of 100 lower than the further chamber or the specimen chamber; wherein the emitter tip, each one of all of the aperture openings of the first aperture unit, and the second aperture opening are positioned to be not in a straight line.

According to another embodiment a charged particle beam apparatus includes a charged particle emitter located within a gun chamber, the gun chamber having a first pressure; the charged particle beam emitter includes an emitter tip adapted for emission of a charged particle beam, a first differential pressure aperture unit including at least one first aperture opening, a second differential pressure aperture unit including a second aperture opening, the second differential pressure aperture separating the gun chamber from a second chamber or a second chamber from a specimen chamber, a beam bending unit for providing a non-straight vision charged particle beam path adapted for preventing direct vision (a straight diffusion path) from the emitter through all of the first aperture openings and through the second aperture opening.

According to another embodiment a charged particle beam apparatus is provided. The apparatus includes: a charged particle beam emitter located within a gun chamber, the gun chamber having a first pressure; the charged particle beam emitter includes an emitter tip adapted for emission of a charged particle beam for impingement on a plurality of impingement locations; a first aperture unit including a first beam blocking area, a second differential pressure aperture unit including a second aperture opening, the second differential pressure aperture separating the gun chamber from a further chamber or a further chamber from a specimen chamber and being adapted for maintaining a pressure difference between the respective two chambers of at least two orders of magnitude. Thereby, the emitter tip, the beam blocking area and each one of the plurality of impingement locations are positioned to prevent a diffusion path from the impingement locations to the emitter.

Embodiments are also directed to apparatuses for carrying out the disclosed methods and including apparatus parts for performing each described method step. These method steps may be performed by way of hardware components, a computer programmed with appropriate software, or by any combination of the above two or in any other manner. Furthermore, embodiments are also directed to methods by which the described apparatus operates. It includes method steps for carrying out every function of the apparatus or manufacturing every part of the apparatus.

### BRIEF DESCRIPTION OF THE DRAWINGS

Some of the above indicated and other more detailed aspects of the invention will be described in the following description and partially illustrated with reference to the figures. Therein:
Fig. 1 shows a schematic drawing of a charged particle beam apparatus with a blocked diffusion path according to an embodiment of the present invention;
Figs. 2A and 2B show schematic drawings illustrating arrangements with a blocked molecule diffusion path according to embodiments of the present invention;
Figs. 3 A and 3B show schematic drawings illustrating further arrangements with a blocked diffusion path according to embodiments of the present invention;
Figs. 4A and 4B show schematic drawings illustrating further arrangements with aperture units including molecule blocking areas;
Figs. 5A and 5B show schematic drawings illustrating further arrangements with aperture units including molecule blocking areas;
Figs. 6A and 6B show schematic drawings illustrating further arrangements with a blocked molecule diffusion path according to embodiments of the present invention;
Fig. 7 shows a schematic drawing of an aperture unit with a molecule blocking area according to the present invention; and
Fig. 8 shows a schematic drawing of a further aperture unit with a molecule blocking area according to the present invention.

### DESCRIPTION OF THE PREFERRED EMBODIMENTS

Reference will now be made in detail to various embodiments, examples of which are illustrated in the drawings. In the figures and the description that follows, like reference numerals refer to similar elements. The example is provided by way of explanation, and is not meant as a limitation of the invention. For example, features illustrated or described as part of one embodiment can be used on or in conjunction with other embodiments to yield yet a further embodiment. It is intended that the present invention includes such modifications and variations.

In particular, the following embodiments will be described with reference to electron beams and field emitters, specifically cold field emitters. This is not to be understood as a limitation to the invention. The invention can also be applied to other charged particles and other types of emitters which require protection from molecules that may adsorb undesirably at the surface thereof. Further, instead of electrons as charged particles, the present invention may also be used for ions and respective ion emitters.

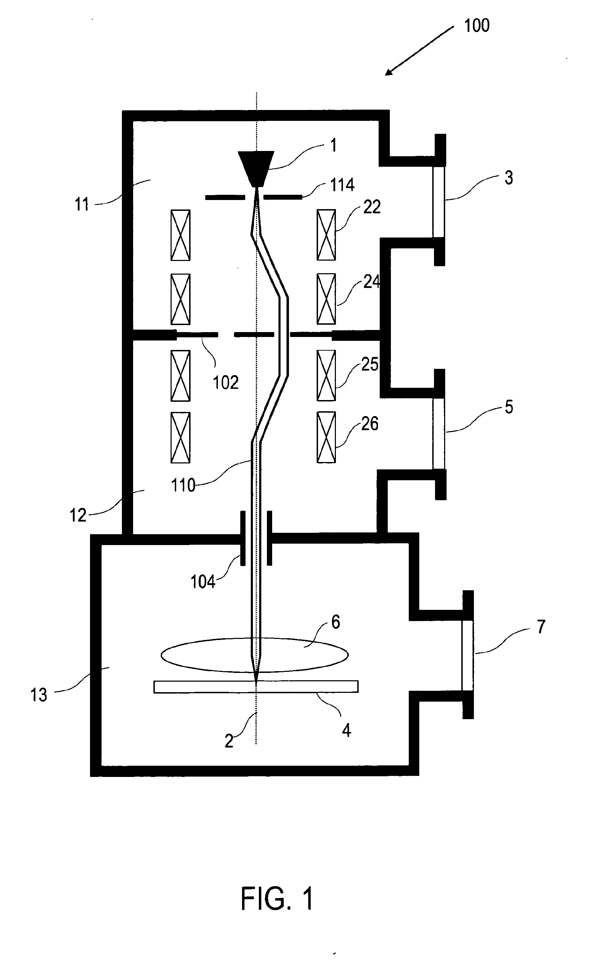

Fig. 1 shows a first embodiment of a charged particle beam apparatus 100. An emitting unit, which comprises an emitter 1 and an extractor 14, emits electron beam 110. The electron beam is to be focused by an objective lens 6 on specimen 4, which is located on a specimen stage (not shown). Without deflection means 22, 24, 25, 26, the beam would travel substantially along optical axis 2. The primary electron beam 110 causes secondary and backscattered particles to be released by specimen 4.

Within fig. 1 the emitting unit is located in gun chamber 11. Electron beam 110 is guided from gun chamber 11 to intermediate vacuum chamber 12 into specimen chamber 13. Each of the chambers has a pumping port 3, 5, and 7, respectively. The three vacuum chambers are separated from each other by differential pressure aperture units 102, 104.

Independent of this specific embodiment, differential pressure apertures can have two different forms. On the one hand, they can be formed by a tube. This form may be used if the diameter of the differential pressure aperture, that is the opening of the differential pressure aperture unit, can not be reduced sufficiently. If the size of the opening needs to be in the range of about 1 mm because of the diameter of the primary electron beam, because of a required deflection of the primary electron beam, because of simplicity of alignment, or because of other reasons, the length of the differential pressure opening needs to be increased in order to increase the resistance for air flowing through the aperture. This form then has typically a diameter of the opening between about 1 mm and about 2 mm and a length of the tube that is about 5 times to about 20 times the diameter. Such a tube differential pressure aperture typically allows for a pressure difference between two orders of magnitude to three orders of magnitude.

On the other hand, the second form for a differential pressure aperture can be a disc with a small opening. Typical thickness of the disc may be in the range of about 100 µm to about 500 µm. Typical diameters of the aperture opening may be in the range of about 20 µm to about 200 µm.

Differential pressure apertures are used as aperture units separating independently evacuateable vacuum chambers and are adapted to hold/maintain a defined pressure difference. This may for example be two to four orders of magnitude.

The embodiment of fig. 1 shows three chambers 11, 12, and 13. Each chamber has a different pressure. For typical arrangements the pressure in the specimen chamber is about 1*10⁻⁶ torr or less (1.333*10⁻⁶ mbar or less). Specimen chamber 13 is pumped with a turbo pump having a pumping speed of for example 300 1/s. The first differential pressure aperture has the form of a tube with the diameter of about 1.5 mm and a length of about 15 mm. The pressure in the intermediate vacuum chamber 12 is about 1*10⁻⁷ torr or less (1.333*10⁻⁷ mbar or less). This chamber is pumped by a 20-60 l/s ion getter pump. Intermediate vacuum chamber 12 and gun chamber 11 are separated from each other by a differential pressure aperture provided by a multi-aperture with holes arranged on a circle. The diameter of the openings of the aperture unit are about 1 mm. This aperture unit is used at the same time as a selectable final aperture for the electron beam.

It may for example also be provided by an aperture opening with a thickness of about 100 µm and a diameter of about 100 µm and may then hold ca. for orders of magnitude in pressure difference.

The final aperture is defined as the last beam shaping aperture. That is, the final aperture blocks a part of the beam to shape the beam. And the final aperture is the last beam shaping aperture before the primary charged particle beam impinges on specimen 4.

Differential pressure aperture unit 102 separates the intermediate vacuum chamber 12 from the gun chamber 11. The upper vacuum chamber, that is the gun chamber, is pumped with an ion getter pump with a pumping speed of about 20-60 l/s. The pressure in the gun chamber is about 1*10⁻¹⁰ torr or less (1.333*10⁻¹⁰ mbar or less).

The aperture openings of differential pressure aperture unit 102 are off-axis. The openings of the aperture unit are not located on optical axis 2. Aperture unit 102 has a molecule blocking area at the position of the optical axis 2. Contrary thereto, the differential pressure aperture unit 104 has its opening on the optical axis 2. In order to guide the primary electron beam through the electron beam column, a deflection system is provided.

Fig. 1 shows a 4-B-deflection system. Thereby, four magnetic deflectors 22, 24, 25, and 26 are used. First deflector 22 deflects the beam away from the optical axis 2, whereas the second deflector 24 redirects the primary electron beam to travel substantially parallel to optical axis 2. As a result of the first two deflectors, the beam travels off-axis. After travelling through the opening of aperture unit 102, primary electron beam 110 is deflected towards optical axis 2 by deflector 25. The fourth deflector 26 redirects the primary electron beam to travel substantially along optical axis 2.

The embodiment of fig. 1 provides a first aperture unit with the first opening, a second aperture unit with at least one second opening and an emitter. The first opening, the second openings and the emitter are not located on one straight line. That is, a molecule blocking area of the aperture unit, the opening of another aperture unit, and the emitter are located on a straight-line. Therefore, molecules defusing from specimen chamber 13 into the intermediate vacuum chamber 12 can not reach the emitter.

In other words, that diffusion path for molecules from the specimen chamber to the emitter is blocked. Molecules originating in specimen chamber 13 and defusing through the opening of the aperture unit separating the specimen chamber from a neighboring chamber is blocked by a molecule blocking area of an aperture unit. Therefore, the probability of molecules originating in the specimen chamber 13 to be adsorbed on a surface of the emitter is reduced.

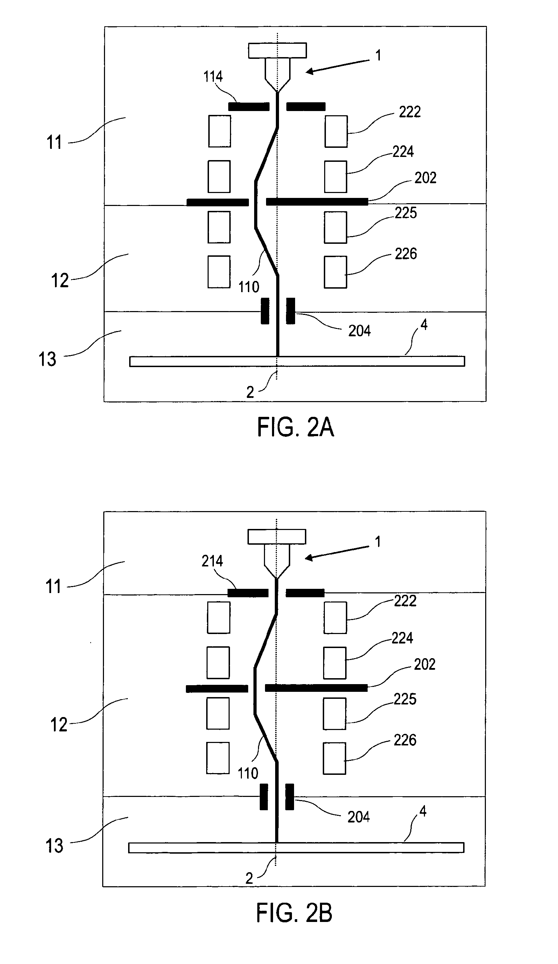

Further embodiments will now be described with respect to figs. 2A and 2B. In fig. 2A, an electron beam 110 emitted by emitter 1 is directed on specimen 4. The electron beam travels through aperture 204, aperture 202 and through component 214. According to one embodiment, component 114 is an extractor.

According to another embodiment (see fig. 2B), component 214 may be a further aperture, particularly a differential pressure aperture, separating the gun chamber from a neighboring chamber. Deflection system including deflectors 222, 224, 225, and 226 guides the electron beam 110 through the various openings in the system. Deflectors 222, 224, 225, and 226 form a 4-stage deflection system. The deflectors may be electrostatic, magnetic or combined magnetic-electrostatic.

Figs. 2A and 2B provide schematic drawings indicating different chambers 11, 12 and 13 of the charged particle column. According to one embodiment (see fig. 2A), aperture unit 204, which may typically be a differential pressure aperture unit, separates the specimen chamber 13 from a neighboring chamber 12. As already explained with respect to fig. 1, the specimen chamber includes an objective lens (not shown in fig. 2), a specimen stage for retaining the specimen and a pumping port. Deflectors 225 and 226 are located in an intermediate vacuum chamber 12, which is separated from the gun chamber 111 by aperture unit 202. Within the gun chamber deflectors 222 and 224 and extractor 114 are provided.

According to another embodiment (see fig. 2B), all four deflectors may be provided within one or more intermediate vacuum chambers. Component 214 is a differential pressure aperture unit. Emitter 1 is located in the gun chamber separated from a neighboring intermediate vacuum chamber by aperture unit 214. In this embodiment, the emitter may be provided with additional extractors or anodes.

Figs. 2A and 2B show aperture units 202, which may be a differential pressure aperture unit, with one opening. Nevertheless, according to a typical arrangement, the opening in the aperture unit 202 may form the final aperture of the charged particle beam column.

Aperture unit 202 has one opening, which is located off-axis. Further, there is the beam blocking area of aperture unit 202, which is located on-axis. Thus, a straight diffusion path for molecules defusing from a lower part of the system, particularly the specimen chamber, is prevented. Thus, the probability of molecules originating from a low part of the system to be adsorbed on the surface of the emitter is reduced.

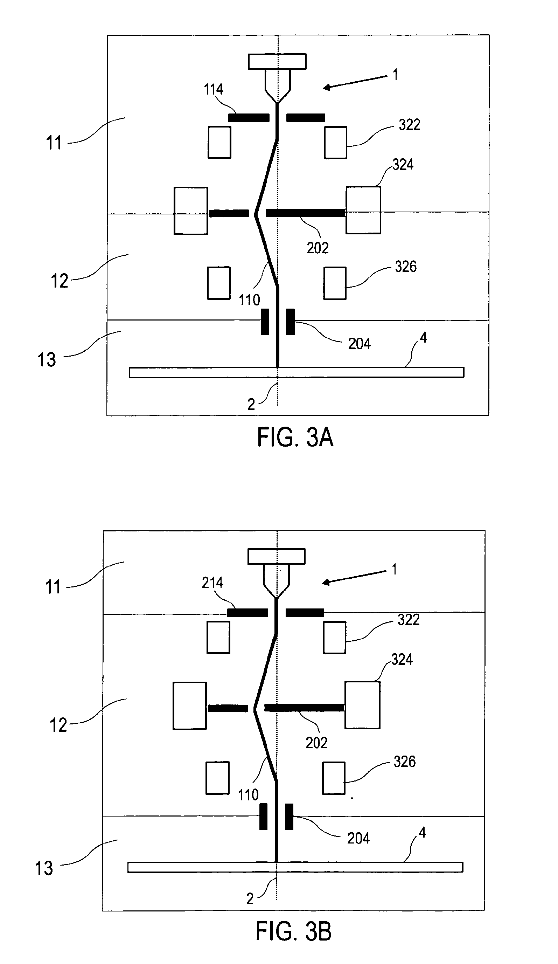

Further embodiments will now be described with respect to figs. 3A and 3B. Therein, aperture units, which may typically be differential pressure aperture units, the emitter, the specimen, and the above described different possible arrangements of chambers may be provided similarly to the embodiments described with respect to figs. 2A and 2B. The deflection systems shown in figs. 3A and 3B are a 3-stage deflection system including deflectors 322, 324 and 326. The deflectors may be electrostatic, magnetic or combined magnetic-electrostatic.

Generally, for all embodiments shown herein, the deflection system may be provided such that after all three or four deflections, respectively, the charged particle beam travels along the same axis as before any of the deflections. Typically this axis will be the optical axis. The electron beam is emitted from the emitter along the optical axis and the last deflector redirects the beam to travel again substantially along the optical axis. Thereby, aberrations introduced by the deflection system are minimized.

For each of the embodiments described herein, this may be realized by a symmetric arrangement of the deflectors. Thereby, in the case of a 4-stage magnetic deflection system, the same absolute values of currents may be applied to all four deflectors. In the case of a 4-stage electrostatic deflection system, the same absolute values of potentials may be applied to all deflectors. Corresponding relationships also apply for combined magnetic-electrostatic deflectors. The relation between the absolute values of the deflection angles can preferably be realized by connecting the deflection stages in one electrical circuit.

In the case of 3-stage deflection systems, the deflection angles may be similar for the first and third deflection stage and, for the second deflection stage, a multiple thereof. If this symmetry is further combined with an arrangement of the deflection stages with respect to each other such that the distance between the first and the second deflection stage is similar to the distance between the second and the third deflection stage, aberrations and dispersion can be minimized. The relation between the absolute values of the deflection angles can preferably be realized by connecting the deflection stages in one electrical circuit.

As an example, within a magnetic 3-stage deflection system, the number of windings of deflected 324 (see figs. 3A and 3B) may be twice as large as the number of findings in deflectors 322 and 326. In fig. 3, this is indicated by the increased size of deflector 324.

If the deflection is realized by connecting the deflection stages in one electrical circuit, variations of the applied current or voltage concern the deflection stages equally. The different deflection directions can be realized by the direction of the windings or the direction of the current applied.

As described e.g. with respect to figs. 1 to 3B the deflection is conducted in a symmetrical manner. Thereby, aberrations can be minimized. However, if e.g. constructional aspects do not allow the symmetrical arrangement, embodiments (not shown) having different deflection angles for all three deflectors can also be realized. Generally, aberrations are minimized as long as the charged particle beam travels substantially along the same axis after deflection of the deflection system as compared to before deflection of the deflection system.

The same above-mentioned arguments apply for the usage of four deflectors. To minimize aberrations in the embodiment of for example figs. 1 to 2B, solely the absolute values of the deflection angles of the first and second deflectors and the absolute values of the deflection angles of the third and fourth deflectors have to be equal in the event the distance from the first deflectors to the second deflector is the same as the distance from the third deflector to the fourth deflector. The charged particle beam can travel substantially parallel to the optical axis through aperture unit 202. That is, the charged particle beam travels substantially perpendicular to the aperture unit through the aperture unit opening. However, this advantage coincides with the disadvantage of increased space requirement and/or column length.

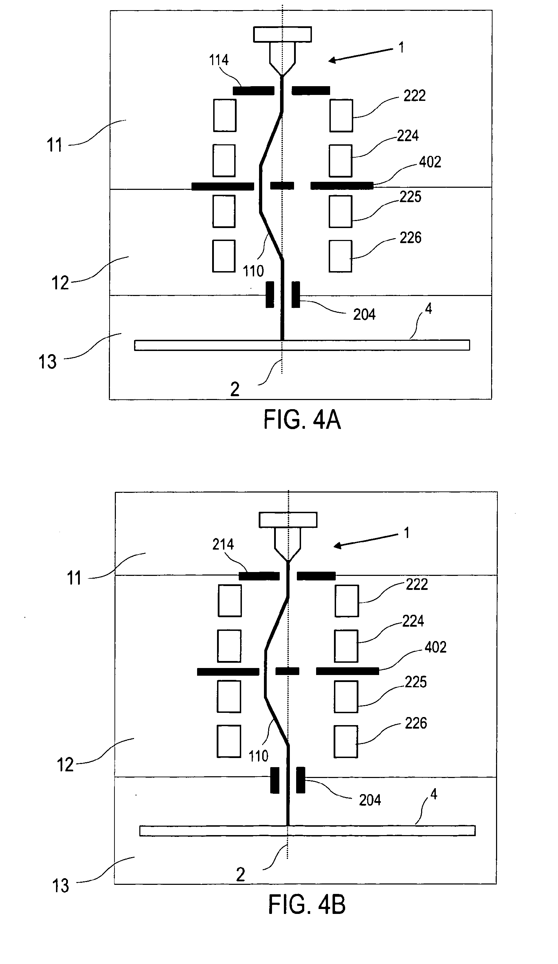

Further embodiments will now be described with respect to figs. 4A and 4B. Figs. 4A and 4B show a 4-stage deflection system including deflectors 222, 224, 225 and 226. Compared to figs. 2A and 2B, the aperture units 402 include a plurality of aperture openings. Thereby, particularly in the event of the aperture unit 402 forming the final aperture, a plurality of aperture openings can be used as desired.

On the one hand, the beam shaping capability of one aperture opening may decrease because of contamination of the aperture opening. Contamination may for example occur since the aperture opening of a final aperture blocks a part of the electron beam. As a result, the area around the aperture opening may get charged. This may again result in attraction of particles which are then located in the area of the aperture opening that is formed to shape the beam. Particles located in the aperture opening can thus deteriorate the beam shaping quality of the final aperture. If the beam shaping quality decreases, another aperture opening of the plurality of openings of the aperture unit 402 may instead be used.

On the other hand, the aperture openings of the aperture unit 402 acting as a final aperture may have different diameters. Thereby, different electron beam diameters and, thus, different beam currents may be generated by switching from one aperture opening to another aperture opening.

Figs. 4A and 4B provide schematic drawings indicating different chambers of the charged particle column. According to one embodiment (see fig. 4A), aperture unit 204, which may typically be a differential pressure aperture unit, separates the specimen chamber from a neighboring chamber. As already explained with respect to fig. 1, the specimen chamber 13 includes an objective lens (not shown in fig. 4), a specimen stage for retaining the specimen and a pumping port. Deflectors 225 and 226 are located in an intermediate vacuum chamber 12, which is separated from the gun chamber by aperture unit 202. Within the gun chamber deflectors 222 and 224 and extractor 114 are provided.

According to another embodiment (see fig. 4B), all four deflectors may be provided within one or more intermediate vacuum chambers. Component 214 is a differential pressure aperture unit. Emitter 1 is located in the gun chamber separated from a neighboring intermediate vacuum chamber by aperture unit 214. In this embodiment, the emitter may be provided with additional extractors or anodes.

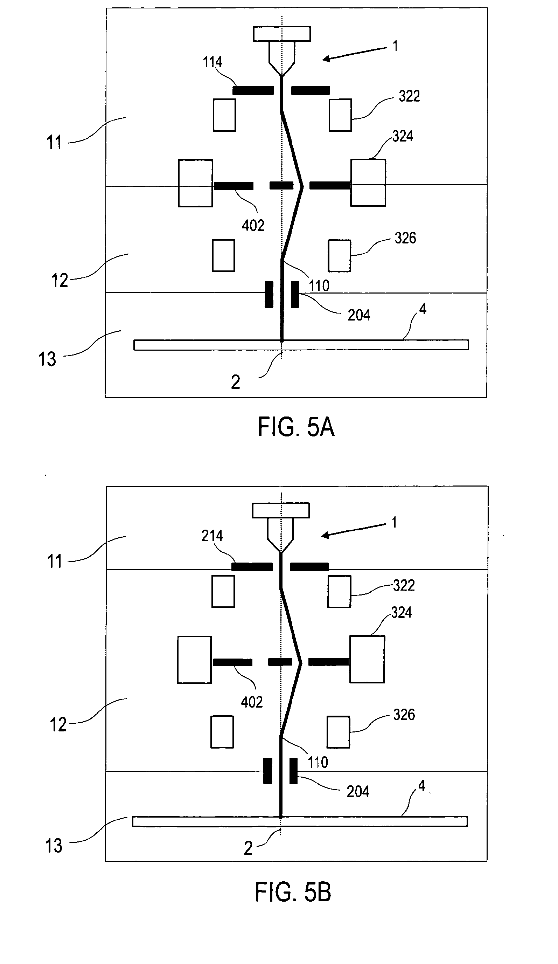

Similar arguments apply to the embodiments described with respect to figs. 5A and 5B. Therein, also an aperture unit 402 with multiple aperture openings is shown. As compared to figs. 4, the embodiments shown in figs. 5 include 3-stage deflection systems as described previously above with respect to figs. 3.

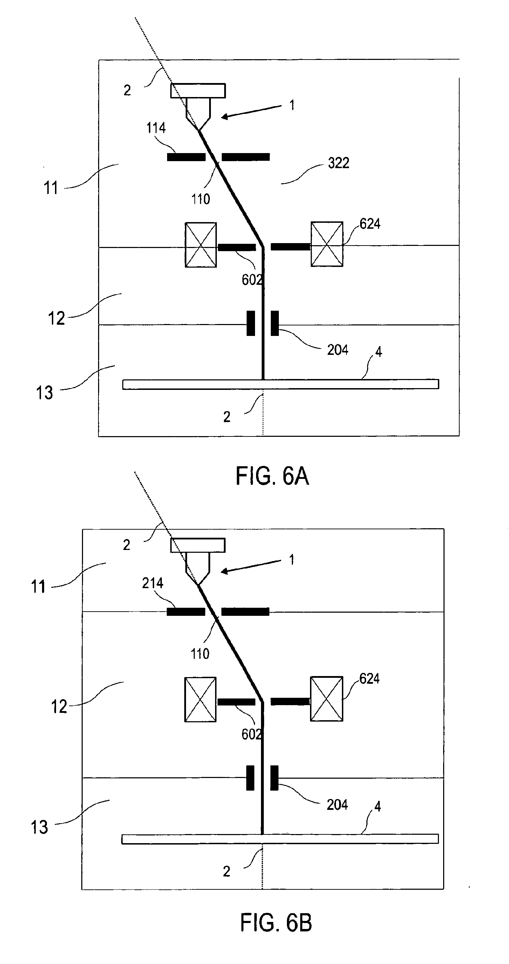

Further embodiments will now be described with respect to figs. 6A and 6B. Fig. 6A shows a charged particle beam system with emitter 1. Electron beam 610 travels through openings of aperture units 602 and 204. Again, the openings of aperture units 602 and 202 are not located on a straight-line with emitter 1. One of the aperture units has a molecule blocking area, which is located on a straight-line with the emitter and the opening of the other aperture unit. Thereby, a straight molecule diffusion path is prevented.

Within figs. 6A and 6B, the optical axis of the electron beam system is bent by deflector 624. The electron beam system is a non-straight vision system. This arrangement also eliminates the direct visibility (straight-line) from the wafer to the tip of the emitter. As a result, the diffusion of molecules from a lower part of the electron system, particularly the specimen chamber, is reduced.

The bending of the optical axis in figs. 6A and 6B is provided by the magnetic deflector. According to another embodiment (not shown), the optical axis may also be bent by a sector field.

Figs. 6A and 6B provide schematic drawings indicating different chambers of the charged particle column. According to one embodiment, aperture unit 204, which may typically be a differential pressure aperture unit, separates a specimen chamber 13 from a neighboring chamber. As already explained with respect to figs. 1, the specimen chamber includes an objective lens (not shown in fig. 6), a specimen stage for retaining the specimen and a pumping port. Aperture unit 204 separates the specimen chamber from a further chamber, an intermediate vacuum chamber 12. Further, aperture 602 may separate the intermediate vacuum chamber from the gun chamber 11. Within the gun chamber extractor 114 is provided.

According to another embodiment (see fig. 6B), deflector 624 and aperture 602 may be provided within one or more intermediate vacuum chambers. Component 214 may illustrate then a differential pressure aperture unit. Emitter 1 is located in the gun chamber separated from a neighboring intermediate vacuum chamber by aperture unit 214. In this embodiment, the emitter may be provided with additional extractors or anodes.

Generally, for all embodiments described with respect to figs. 2 to 6B, also charged particle beam columns with two vacuum chambers and, for example, four vacuum chambers may be provided to yield even further embodiments. If two vacuum chambers are provided, any one of the aperture units (204, 202, 402, 214) may be used as aperture units not separating independently evacuateable vacuum chambers. In this case, one of the aperture units may be located within one pressure stage.

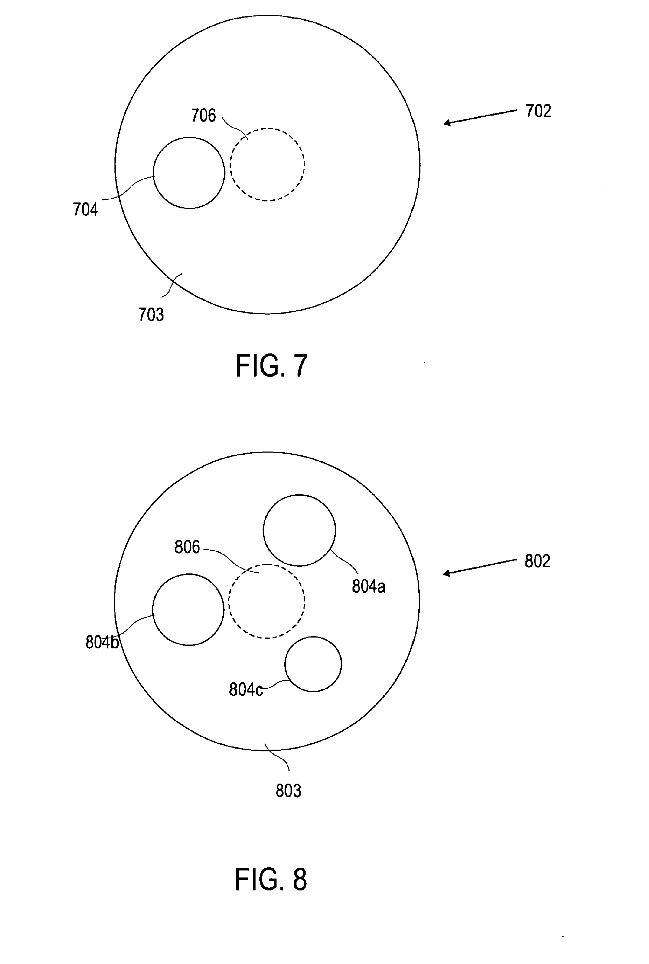

Embodiments of aperture units, particularly differential pressure aperture units will now be described with respect to figs. 7 and 8. Fig. 7 shows aperture unit 702 having a disk element 703 including molecule blocking area 706. Area 706 is indicated by dashed lines. Aperture unit 702 further includes aperture opening 704, which is provided outside the center axis of the aperture unit. In the event aperture unit 702 is provided as a differential pressure aperture unit, opening 704 may be formed of an elongated tube to increase the pressure resistance of the differential pressure aperture unit, as generally described above.

Fig. 8 shows an aperture unit 802. Aperture unit 802 includes disk element 803 with molecule blocking area 806. Molecule blocking area 806 is indicated with dashed lines in fig. 8. Contrary to the embodiment explained with respect to fig. 7, fig. 8 includes a plurality of aperture openings 804a, 804b, and 804c.

On the one hand, aperture openings 804 may have the same diameter. Thereby, redundancy of aperture openings may be provided. On the other hand, particularly if the aperture unit 802 is used as a final aperture or another beam shaping aperture, aperture openings 804 may have differently sized openings. Thereby, one of the differently sized openings may be chosen according to the desired application. Further, it is possible that some of the aperture openings 804 have the same diameter to provide redundancy and some of the openings have different diameters to be able to adapt the charged particle beam diameter to the desired application.

Again, openings 804 may be formed of an elongated tube to increase the pressure resistance of the differential pressure aperture unit, as generally described above.

In Fig. 8, the aperture openings 804 are positioned off-axis so that a direct sight from the wafer to the emitter is prevented. If the aperture openings are at the same time used to form the final apertures, multiple apertures may typically be provided. The openings may then be arranged on a circle concentric to the optical axis. The embodiment shown in fig. 1 has three aperture openings. However, according to different embodiments, also two, four, five, six or even a higher number of aperture openings may be provided in the aperture unit 802.

Independent of a specific embodiment, the at least three openings may typically be positioned on a concentric circle around the optical axis or the molecule blocking area.

Having thus described the invention in detail, it should be apparent for a person skilled in the art that various modifications can be made in the present invention without departing from the spirit and scope of the following claims.

## Claims

1. A charged particle beam apparatus (100) comprising:
a charged particle emitter (1) located within a gun chamber (11), the gun chamber being adapted to encompass a first pressure;
at least one further vacuum chamber adapted to encompass a second pressure between one order and four orders of magnitude higher than the first pressure;
a first aperture unit (102; 202, 402; 602; 702; 802) comprising a molecule blocking area and at least one first aperture opening;
a second aperture unit (104; 204, 214) comprising a second aperture opening;
wherein the at least one first aperture unit and/or the second aperture unit is a differential pressure aperture separating two independently evacuateable vacuum chambers and being adapted for maintaining a pressure difference of at least two orders of magnitude; and
wherein the emitter, the molecule blocking area (706; 806) and the second aperture opening are positioned to be on a straight line.

2. The charged particle beam apparatus according to claim 1, further comprising
wherein the second aperture unit is a differential pressure aperture separating the gun chamber from the further vacuum chamber and being adapted for maintaining a pressure difference of at least two orders of magnitude.

3. The charged particle beam apparatus according to claim 1, further comprising
a specimen chamber (13) being adapted to encompass a third pressure between one order and four orders of magnitude higher than the second pressure;
wherein the second aperture unit is a differential pressure aperture separating the specimen chamber from the further vacuum chamber and being adapted for holding a pressure difference of at least two orders of magnitude.

4. The charged particle beam apparatus (100) according to claim 3,
wherein
the first aperture unit is a differential pressure aperture separating the further vacuum chamber from the gun chamber and being adapted for maintaining a pressure difference of at least two orders of magnitude.

5. The charged particle beam apparatus according to any of claims 3 to 4,
wherein
the aperture unit comprises the final aperture of the charged particle beam apparatus.

6. The charged particle beam apparatus according to any of claims 3 to 5,
wherein
the first aperture unit (802) is a multiple aperture unit.

7. The charged particle beam apparatus according to any of claims 1 to 6,
wherein
the first pressure is below 1*10-9 mbar and the second pressure is below 1*10-6 mbar.

8. The charged particle beam apparatus according to any of claims 3 to 7,
wherein
the third pressure is below 1*10-5 mbar.

9. The charged particle beam apparatus according to any of claims 1 to 8,
wherein
the molecule blocking area is located on an optical axis (2) of the charged particle beam apparatus, the second aperture opening is located on the optical axis and the aperture openings of the at least one first aperture opening are located off-axis from the optical axis.

10. The charged particle beam apparatus (100) according to any of claims 3 to 7, further comprising:
a deflection system for directing the charged particle beam through one of the at least one first aperture opening and the second aperture opening.

11. The charged particle beam apparatus according to claim 10, wherein
the deflection system is a 3-stage deflection system or a 4-stage deflection system adapted to deflect the charged particle beam travelling along the optical axis before the deflection system to travel substantially along the optical axis after the deflection system.

12. Charged particle beam apparatus according to claim 11, wherein the deflector system is symmetrical regarding a middle deflector of the three deflectors of the 3-stage deflection system or regarding a plane between the second and the third deflector of the 4-stage deflection system.

13. Method of protecting an emitter tip with an aperture comprising the steps of:
Providing an emitter (1) for emission of a charged particle beam within a gun chamber (11);
Providing a first aperture unit;
Providing a second differential pressure aperture unit separating two independently evacuateable vacuum chambers and being adapted for maintaining a pressure difference of at least two orders of magnitude;
Deflecting the charged particle beam through openings of the first aperture unit and the second differential pressure aperture unit on a path different from diffusion paths of molecules originating in a specimen chamber; and
Blocking the diffusion paths of molecules originating in the specimen chamber to the emitter by the combined action of the first aperture unit and the second differential pressure aperture unit.
